# EUROPEAN PATENT SPECIFICATION

(11) **EP 0 539 211 B1**
(45) Date of publication and mention of the grant of the patent: **01.10.1997**
(21) Application number: 92309717.4
(22) Date of filing: 23.10.1992
(51) Int. Cl.: H01L 21/60, H01L 23/482, B01J 13/18, H01B 1/22, C09J 9/02, C08F 292/00

(54) **Method for production of microcapsule type conductive filler**
Verfahren zum Herstellen eines leitenden Füllstoffs vom Mikrokapseltyp
Procédé de fabrication d'un matériau de remplissage conducteur du type à microcapsule

(30) Priority: 24.10.1991 JP 303818/91; 04.09.1992 JP 263219/92
(43) Date of publication of application: 28.04.1993
(60) Divisional application: 97103551.4
(73) Proprietor: FUJITSU LIMITED, Kawasaki-shi, Kanagawa 211 (JP)
(72) Inventor: Date, Hiroaki, c/o Fujitsu Limited, Kawasaki-shi, Kanagawa 211 (JP); Usui, Makoto, c/o Fujitsu Limited, Kawasaki-shi, Kanagawa 211 (JP); Watanabe, Isao, c/o Fujitsu Limited, Kawasaki-shi, Kanagawa 211 (JP); Hozumi, Yuko, c/o Fujitsu Limited, Kawasaki-shi, Kanagawa 211 (JP)
(74) Representative: Silverman, Warren

(56) References cited:
- PATENT ABSTRACTS OF JAPAN vol. 17, no. 233 (M-1407)12 May 1993 & JP-A-04 362 104 (FUJITSU) 15 December 1992
- DATABASE WPI Week 934, Derwent Publications Ltd., London, GB; AN 93-033291 & JP-A-4 362 104 (FUJITSU)
- DATABASE WPI Week 9220, Derwent Publications Ltd., London, GB; AN 92-162197 & JP-A-4 096 981 (FUJITSU) 30 March 1992
- PATENT ABSTRACTS OF JAPAN vol. 14, no. 316 (E-949)6 July 1990 & JP-A-02 103 874 (STANLEY ELECTRIC CO.) 16 April 1990
- PATENT ABSTRACTS OF JAPAN vol. 14, no. 316 (E-949)6 July 1990 & JP-A-02 103 875 (STANLEY ELECTRIC CO.) 16 April 1990

## Description

This invention relates to a method for the production of a microcapsule (MC) type conductive filler and more particularly to a method for coating the surface of minute conductive particles with an insulating polymer and to an MC type adhesive agent having dispersed in an adhesive agent the coated MC type conductive filler.

In a conventional method of adhering one part to another part so that the interface between the two parts is conductive, soft soldering or welding is used. The conventional method is effectively applicable only to a limited number of materials because of the heat required. In contrast, an organic-inorganic composite conductive adhesive agent, that is composed of a binder using a synthetic resin as a main component thereof and a conductive filler using a metal powder as a main component thereof, finds utility in a wide variety of applications that involve different kinds of materials to be subjected to adhesion. This type of adhesive agent is therefore an indispensable medium for conductive adhesion of plastic substances (such as epoxy and phenol resins) that do not adhere by soft soldering, for adhesion of NESA glass used in liquid crystal display devices, for adhesion of phosphor bronze with a carbon brush used in micrometers, and for adhesion of lead wires as in quartz oscillators and sdc meters, for example.

Particularly, in the semiconductor industry, which has been enjoying significant growth recently, IC's and LSI's of increasingly high quality have been developed and mass produced. Once the method using an Au-Sn eutectic was used for the adhesion of semiconductor chips (silicon wafers) to lead frames. However, conductive adhesive agents formed by kneading an epoxy resin with silver powder now have multiple utility owing to their lower cost and ability to enhance productivity.

While epoxy resin is generally used as a resin binder for conductive adhesive agents, polyimide type, phenol type and polyester type resins are also used, though only partially. Minute particles of such metals as gold, silver and copper and amorphous carbon and graphite powder are generally used as a conductive filler. Metal oxides are also used, though only partially. Silver powder is preferably used over the conductive fillers cited above because it is inexpensive, reliable and effective.

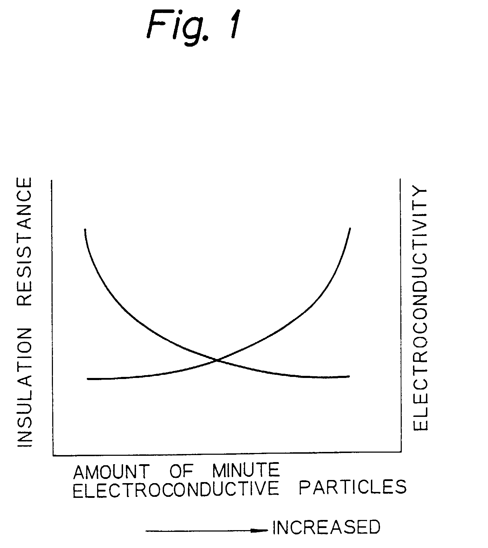

Conductive adhesive agents are advantageous in various respects compared with conventional applications such as soft soldering and welding, although they are not perfectly free from fault. For example, when a conductive adhesive agent is used between an LSI chip and patterns for mounting component parts, an increase in the amount of minute conductive particles that are incorporated in the conductive adhesive agent lowers insulation resistance and increases the possibility of adjacent patterns forming electrical continuity. This is illustrated in Fig. 1 of the accompanying drawings which is a graph showing the relationship between insulation resistance and conductivity with the amount of minute conductive particles as a parameter. A reduction in the amount of minute conductive particles reduces the electrical continuity between the LSI and the patterns. Data indicate the necessity for rigidly controlling the amount of minute conductive particles to be used in the conductive adhesive agent, and at the same time, reveal the fact that the minute conductive particles cannot be used in large amounts.

It is believed that this problem can be solved by a procedure that comprises preparing an MC type conductive adhesive agent by dispersing in an adhesive agent an MC type conductive filler formed by coating the surface of minute conductive particles with an insulating polymer, applying the MC type conductive adhesive agent to the entire surface of the substrate of an IC or LSI chip, exerting pressure to bear on the interface between the chip and patterns deposited thereon, thereby rupturing the coating layer of the capsules and establishing electrical continuity between the chip and the patterns, and meanwhile allowing the encapsulated minute conductive particles interposed between the adjacent patterns to remain intact and continue to insulate these patterns from one another.

The insulating resins that can be used to coat the surface of minute conductive particles include thermoplastic resins and thermosetting resins as classified by kind. In terms of resistance to moisture absorption and electrical insulating properties, thermosetting resins definitely excel thermoplastic resins. Since thermocompression bonding of a chip to a substrate is generally carried out at an elevated temperature of at least 170°C, the insulating resin to be used is required to be stable enough to resist this elevated temperature. However, few thermoplastic resins can endure this temperature. By contrast, most thermosetting resins can tolerate temperatures in the region of 200°C.

Where use as an insulating resin in an MC type conductive filler is concerned, thermosetting resins are advantageous in various respects over thermoplastic resins.

The predominant procedure for the application of an insulating resin coating to the surface of minute conductive particles is that which involves dissolving the resin in a solvent, spraying the resulting solution on the surface of the minute conductive particles, and drying the applied coating of the solution. However, since thermosetting resins are insoluble in solvents, this procedure is difficult and the application of a thermosetting resin coating to the surface of minute conductive particles, therefore, necessitates the development of a novel coating procedure.

Prior techniques pertaining to the MC type conductive adhesive agent have been disclosed by, for example, Japanese Unexamined Patent Publications No. 176,139/1987, No. 76,215/1987, No. 47,943/1988, No. 54,796/1988, No. 103,874/1990 and No. 103,875/1990.

First, the disclosures of Japanese Unexamined Patent Publications No. 176,139/1987, No. 76,215/1987, No. 47,943/1988, and No. 54,796/1988 will be described. These patent publications disclose conductive adhesive agents produced by forming an intermediate conductive layer on spherical cores of resin and coating the intermediate layer with a surface layer of an insulating thermoplastic resin, and conductive adhesive agents produced by coating the surface of minute spherical conductive particles with an insulating thermoplastic resin. Actual mounting of a chip on a substrate for a printed circuit by using such a conductive adhesive agent is attained by a procedure that comprises applying the conductive adhesive agent to the substrate and thermocompression bonding the chip to the substrate so that, in use, the intermediate layer of the minute conductive particles has a conductive function and the insulating thermoplastic resin has an adhesive and insulating function. The techniques disclosed by these patent publications differ from the method using the MC type conductive adhesive agent of the present invention and these patent publications do not mention using a thermosetting resin as an insulating resin for coating the surface of the minute conductive particles.

Referring now to the disclosure of Japanese Unexamined Patent Publication No. 103,874/1990, the invention of this patent publication pertains to an MC type conductive adhesive agent produced by dispersing, in a film of an insulating adhesive agent serving as a binder, an MC type conductive filler having minute conductive particles coated with an insulating thermoplastic resin or thermosetting resin. Conductive union of two given members using this MC type conductive adhesive agent is accomplished by depositing the adhesive agent on the two members and pressing the two members against each other while being heated. Thus, in the part expected to form electrical continuity, the pressure exerted as described above ruptures the insulating resin layer of the MC filler and establishes the desired electrical continuity. In the part requiring insulation, the MC type conductive filler is allowed to remain intact and, therefore, retains stable insulation. Incidentally, this MC type conductive filler is manufactured by plasma polymerization or plasma CVD polymerization and there are times when the insulating film of the MC type filler may be formed of a thermosetting resin. The number of kinds of thermosetting resins that can be manufactured by the plasma polymerization and the plasma CVD polymerization is very small because of the small number of kinds of gases that can be used for injection during the polymerization. Further in accordance with this method of plasma polymerization or plasma CVD polymerization, the cost is sufficiently high to render the manufacturing thereof impracticable and productivity is inferior because the amount of MC type filler that can be manufactured is small.

Japanese Unexamined Patent Publication No. 103,875/1990 discloses the use of an MC type conductive adhesive agent produced by coating minute conductive particles with an insulating thermoplastic resin or thermosetting resin. Actual mounting of a chip on a substrate for a printed circuit using this MC type conductive adhesive agent is attained by applying the conductive adhesive agent to the substrate and thermocompression bonding the chip to the substrate. The intermediate layer of the minute conductive particles has a conductive function and the insulating resin on the surface of the minute conductive particles has an adhesive and insulating function. This MC type conductive filler is manufactured by either plasma polymerization or plasma CVD polymerization. These prior techniques are described as allowing what is formed by coating the surface of minute conductive particles with a thermosetting resin. In spite of these disclosures, thermosetting resins should be unusable for the purpose of coating because they do not melt with heat and, therefore, are incapable of functioning as an adhesive. Even if a thermosetting resin is used, the method of manufacturing the MC type conductive filler entails a serious drawback, as pointed out in Japanese Unexamined Patent Publication No. 103,874/1990.

Practically all of the prior techniques pertaining to the manufacture of an MC type conductive filler or a conductive adhesive agent using this filler invariably use a thermoplastic resin. Even when the use of a thermosetting resin is mentioned, methods of manufacturing using such a thermosetting resin are not disclosed with sufficient specificity or are devoid of practicability and thus, these methods cannot be actually used.

This invention has been produced for the purpose of solving the problems encountered by the prior art described above.

According to a first aspect of the present invention, there is provided a process for the production of a microcapsule (MC) type conductive filler, characterised by:
(a) treating minute conductive particles with a coupling agent;
(b) preparing an oil phase by adding said minute conductive particles to a solvent having dissolved therein a reactive substance A having a solubility parameter which is within ±10 (cal/cm³)^{½} (1cal = 4.186J) of the solubility parameter of said coupling agent, so that said minute conductive particles have said reactive substance A directly on the surface thereof;
(c) dispersing said oil phase in water to form a suspension of said oil phase in water, said water including a reactive substance B capable of reacting with the reactive substance A and a viscosity enhancer such that the viscosity thereof is in the range of from 20 to 10,000 cps; and
(d) stirring said suspension at a rate in the range of from 50 to 250 rpm, and applying heat or adding a catalyst to the suspension to cause said reactive substances A and B to react on the surface of said minute conductive particles and thereby form a coating of a thermosetting, thermoplastic or combined thermosetting/thermoplastic insulating resin on the surface of said minute conductive particles, depending on the nature of the reactive substances A and B.

According to a second aspect of the present invention, there is provided a process for the production of a microcapsule (MC) type conductive filler, characterised by:
(a) treating minute conductive particles with a coupling agent;
(b) preparing an oil phase by adding said minute conductive particles to a solvent having dissolved therein a reactive substance A having a solubility parameter which is within ±10 (cal/cm³)^{½} (1cal = 4.186J) of the solubility parameter of said coupling agent, so that said minute conductive particles have said reactive substance A directly on the surface thereof;
(c) dispersing said oil phase in water to form a suspension of said oil phase in water, said water including a viscosity enhancer such that the viscosity thereof is in the range of from 20 to 10,000 cps; and
(d) stirring said suspension at a rate in the range of from 50 to 250 rpm, and applying heat or adding a catalyst to the suspension to cause said reactive substance A to react on the surface of said minute conductive particles and thereby form a coating of a thermosetting or thermoplastic insulating resin on the surface of said minute conductive particles, depending on the nature of the reactive substance A.

The term "reactive substance" as used in this specification refers to a substance that is capable of forming an insulating polymer on the surface of a filler either by itself or through reaction with another reactive substance. The substances that answer this description include, for example, monomer components, oligomer components, and polymer components that form an insulating polymer.

According to a third aspect of the present invention, there is provided an MC type conductive filler produced by the method of either of the first or second aspects of the present invention, the coating having a thickness of not more than 3µm.

According to a fourth aspect of this invention, there is provided an MC type conductive adhesive agent having dispersed in an adhesive agent the MC conductive filler according to the third aspect of the present invention.

For a better understanding of the invention, and to show how the same may be carried into effect, reference will now be made, by way of example, to the accompanying drawings, in which:-
Fig. 1 is a graph showing the relationship between insulation resistance and conductivity with the amount of minute conductive particles as a parameter;
Fig. 2 is a flow diagram illustrating one method for the production of a microcapsule type conductive filler according to the first aspect of the present invention;
Fig. 3 is a schematic cross-sectional view of the microcapsule type conductive filler;
Fig. 4 is a schematic view of one example of a substrate;
Fig. 5 is a schematic view of one example of a glass chip;
Fig. 6 is a schematic view showing sites for determination of electric continuity resistance and insulation resistance;
Fig. 7 is a partially magnified diagram of Fig. 6;
Fig. 8 is a photomicrograph of a microcapsule type conductive filler (15,000 x magnification);
Fig. 9 is a photomicrograph of a part of union between a bump and a pad (504 x magnification);
Fig. 10 is a schematic view illustrating the union between a chip and a substrate; and

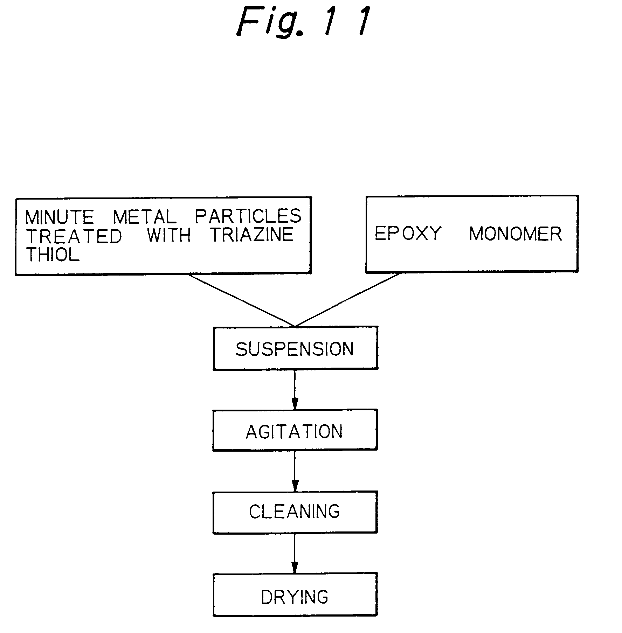

Fig. 11 is a flow diagram showing one method for the production of a microcapsule type conductive filler in accordance with the second aspect of this invention.

The principle of a process for the production of an MC conductive filler according to the first aspect of the present invention is as follows:

A suspension is produced by dispersing minute conductive particles having the surface thereof treated with a coupling agent in a solution of a monomer in a solvent (oil phase) and adding the resultant dispersion dropwise to water having another monomer, an emulsifier, and a viscosity enhancer dissolved therein (aqueous phase). By applying heat or adding a catalyst to this suspension, the monomers are interfacially polymerized on the surface of the minute conductive particles and allowed to coat the minute conductive particles. Alternatively, coating can be effected by preparing a suspension having at least two kinds of monomers dissolved in the oil phase and subjecting the monomers to in situ polymerization. Examples of the monomers that are usable in the form of a combination of two monomers herein are epoxy/amine and bismaleimide/amine (both producing a thermosetting polymer).

The principle of a process for the production of an MC conductive filler according to the second aspect of the present invention is as follows.

A suspension is produced by dispersing minute conductive particles having the surface thereof treated with a coupling agent in a solution of a monomer and a reaction initiator (oil phase) and adding the resultant dispersion dropwise to water having an emulsifier and a viscosity enhancer dissolved therein (aqueous phase). By applying heat to this suspension, the monomer is polymerized in situ on the surface of the minute conductive particles and allowed to form a coating thereon. Examples of the monomer that is usable herein are divinyl benzene and acryl. A thermosetting polymer is obtained from divinyl benzene monomer and a thermoplastic polymer from acryl monomer.

In the production of the MC conductive filler, the following points must be taken into consideration.

(1) The minute conductive particles should be treated in advance with a coupling agent. (2) The sp value of the coupling agent to be used for this treatment should be within ±10 (cal/cm³)^{½} of that of the monomer to be used. (3) The viscosity of the aqueous phase should be in the range between 20 and 10,000 cps. (4) The suspension should be stirred at a rate in the range between 50 and 250 rpm to effect the reaction of the monomer. The reason for (1) is that the monomolecular film of the coupling agent on the surface of the minute conductive particles intertwines with the monomer molecules so that the monomer is retained on the surface of the minute conductive particles and coating is effected uniformly. The reason for (2) is that, if the sp value deviates from the range of ±10 (cal/cm³)^{½}, the monomer is not thoroughly intertwined with the coupling agent and is retained on the surface of minute conductive particles with difficulty. The reason for (3) is that the minute conductive particles settle and agglomerate if the viscosity is less than 20 cps and the separation of the MC type conductive filler after completion of coating is not obtained if the viscosity exceeds 10,000 cps. The reason for (4) is that the minute conductive particles settle and agglomerate during the reaction of the monomer if agitation is omitted.

The minute conductive particles are preferably of a conductive metallic material. The kind of metallic material is irrespective. For example, minute Cu particles having the surface thereof coated with Ag or minute Ag particles are preferably used.

The minute conductive particles are preferably spheres or pseudospheres in shape. Furthermore, the minute conductive particles preferably have a diameter of not more than 50 µm.

The insulating layer of a thermosetting resin for the MC type conductive filler is preferably made of a cured epoxy/amine or bismaleimide/amine type resin. The insulating layer of the MC type conductive filler preferably has a thickness of not more than 3 µm.

The adhesive agent that can be effectively used in the MC type conductive adhesive agent of the fourth aspect of the invention is the same as mentioned above. For example, an epoxy type one-component polyimide or polyester adhesive agent is preferably used.

The viscosity of the adhesive agent mentioned above is preferably not more than 150,000 cps. The content of the MC type conductive filler in the MC type conductive adhesive agent is preferably not more than 50% by volume.

One preferred embodiment of the method of the first aspect of the invention comprises forming a suspension by uniformly dispersing minute conductive particles allowing the presence of a solvent and a monomer (monomer A) on the surface thereof in water having another monomer (monomer B) dissolved therein and applying heat to the suspension thereby inducing the two monomers to react on the surface of the minute conductive particles and form an insulating polymer, and consequently producing a microcapsule type filler. In this method, the monomer A and the monomer B are monomer components that are intended to form an insulating polymer. When a polyamide is intended to form the insulating polymer, for example, adipic acid dichloride serves as the monomer A and hexamethylene diamine as the monomer B. Where polyurethane is intended to form the insulating polymer, for example, tetramethylene diisocyanate serves as the monomer A and methamethylene glycol as the monomer B.

The solvents that are effectively usable for dissolving the monomer A include dichloroethane, chloroform, carbon tetrachloride, xylene, toluene, benzene, dichloromethane, and ethyl acetate, for example. The suspension is heated for the purpose of promoting the reaction of the monomers therein. The temperature of this heating is preferably in the range between normal room temperature and boiling point of the solvent. It is selected in accordance with the particular quality of the suspension to be heated.

In the method described above, the minute conductive particles must be treated with a coupling agent before using. This treatment serves the purpose of fixing the monomer A on the minute conductive particles.

Further, in the method described above, the viscosity of the aqueous phase having the monomer B dissolved therein is preferably adjusted so as to fall in the range between 20 and 10,000 cps by the addition of a viscosity enhancer. During the application of heat to the suspension mentioned above, the suspension must be stirred at a rate in the range between 50 and 250 rpm for reacting the two monomers.

The monomers are preferably used in an amount that is at least sufficient for the monomers to form a film of not less than 0.05 µm in thickness on the surface of the minute conductive particles.

Now, the present invention will be described in detail below with reference to working examples. Of course, this invention is not limited to the working examples.

### Example 1

A microcapsule type conductive adhesive agent was produced with the following materials.

Minute conductive particles: Minute pseudospheres of Cu having the surface thereof plated with Ag (Ag/Cu, average diameter 5 µm).

Dispersant: Titanate type coupling agent.

Monomers: Bisphenol A type epoxy (BPA) and tetraethylene pentamine (TEPA).

Adhesive agent: Epoxy type one-component adhesive agent.

(1) Production of microcapsule type conductive filler (using a monomer and a solvent in the oil phase and a monomer in the aqueous phase).

### 1.1 Treatment of fine metallic particles with a coupling agent

To ensure retention of the monomer on the surface of fine metallic particles, the following treatment with a coupling agent was carried out. In 50 ml of ethanol, 0.3 g of a titanate type coupling agent and 6 g of minute Ag/Cu particles were retained at 60°C and subjected to ultrasonic dispersion for 10 minutes. Then, by keeping the solution at 60°C and expelling ethanol by distillation, treatment of the surface of minute metallic particles with the coupling agent was effected. Incidentally, the amount of coupling agent to be used is preferably in the range of 0.1 to 10% by weight, and is more preferably 5% by weight, based on the amount of the minute metallic particles. The reasons for this particular range are that the surface of the minute metallic particles cannot be uniformly coated with the coupling agent if the amount of coupling agent is less than 0.1% by weight and that the minute metallic particles cohere if the amount exceeds 10% by weight. Further, the solubility parameter of the coupling agent is within ±10 (cal/cm³)^{½} of that of the monomer to be used in the oil phase. This range is important for the purpose of improving the molecular intertwining of the coupling agent and the monomer.

### 1.2 Preparation of aqueous phase

An aqueous phase was prepared by dissolving 1.5 g of an emulsifier, 14.5 g of PVA (viscosity of the aqueous phase 20 cps), and 10 g of TEPA in 200 ml of water. The amount of PVA to be added must be controlled so as to adjust the viscosity of the aqueous phase to preclude the otherwise possible sedimentation of the minute metallic particles.

### 1.3 Preparation of oil phase

An oil phase was prepared by dissolving 10 g of BPA in 30 ml of ethyl acetate and adding 7 g of minute Ag/Cu particles to the resultant solution. The solvent to be used for the oil phase must preferably exhibit solubility of not less than 0.1% in water. If a solvent not satisfying this condition is used, the solvent in the produced MC filler intervenes between the polymer and the minute metallic particles and, when this MC filler is used in a conductive adhesive agent, the entrapped solvent causes corrosion of the product of union. The solubility of the solvent to be used is preferably about 3% in water.

### 1.4 Dispersion of minute Ag/Cu particles

The oil phase was exposed to an ultrasonic wave for 10 minutes to effect thorough dispersion of the minute Ag/Cu particles therein. Although the minute Ag/Cu particles used in this example were spherical in shape, coating is equally effective when the particles are pseudospheres or fish scales in shape. When the MC filler is intended for use in an MC type conductive adhesive agent, the fish scale-shaped particles are not used advantageously because they do not serve as spacers between the bump and the pad, as shown in Table 8 below.

### 1.5 Preparation of suspension

A suspension was prepared by stirring the aqueous phase with a homogenizer at a rate of 4,000 rpm and, at the same time, adding the oil phase gradually to the stirred aqueous phase dropwise. The operating speed of the homogenizer must preferably be in the range of from 500 to 10,000 rpm. The reason for this particular range is that no homogeneous suspension is obtained if the speed is less than 500 rpm and the minute Ag/Cu particles are damaged if the speed exceeds 10,000 rpm.

### 1.6 Interfacial polymerization reaction

The suspension prepared in 1.5 above was stirred with a three-one motor at 150 rpm and heated at 60°C for four hours to induce a reaction. The stirring must be carried out with an operational speed kept in the range between 50 and 250 rpm, so as to prevent sedimentation of the minute metallic particles (which occurs if the speed is less than 50 rpm) and cohesion (which occurs if the speed is larger than 250 rpm) during the interfacial polymerization reaction.

### (2) Observation of cross section of microcapsule type conductor filler

The microcapsule type conductive filler produced as described above was buried in an epoxy resin, allowed to set therein, and cut with a microtome to expose the cross section of the filler for visual observation of coating.

### (3) Confirmation of insulation of microcapsule type conductive filler

The filler was dispersed between two opposed glass substrates having the surface thereof coated with ITO and tested for insulation between the glass substrates.

### (4) Preparation of conductive adhesive agent

The microcapsule type conductive filler prepared in (1) above was mixed in a voluminal proportion of 20% with an epoxy type one-component adhesive agent. The resultant mixture was thoroughly stirred to effect dispersion of the filler therein to provide a microcapsule type conductive adhesive agent.

### (5) Bonding of chip to substrate

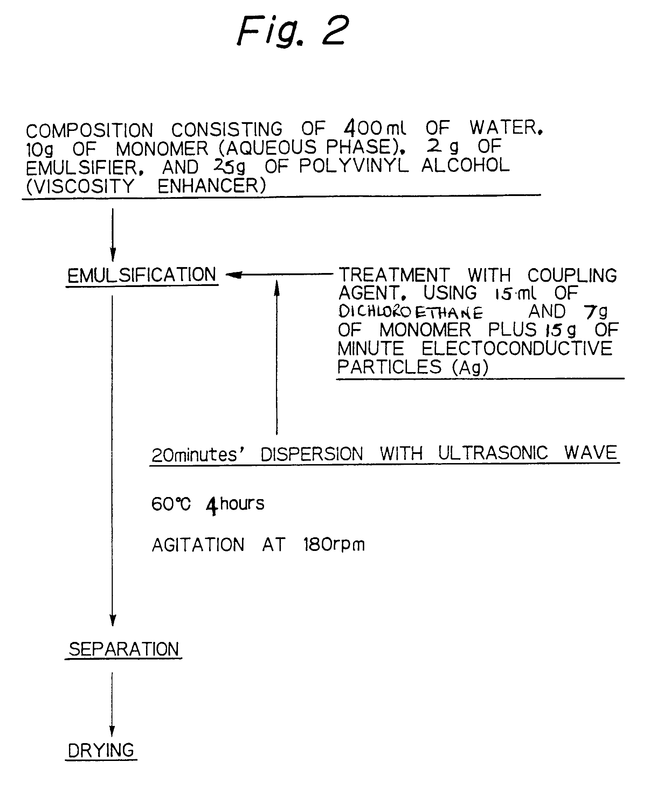

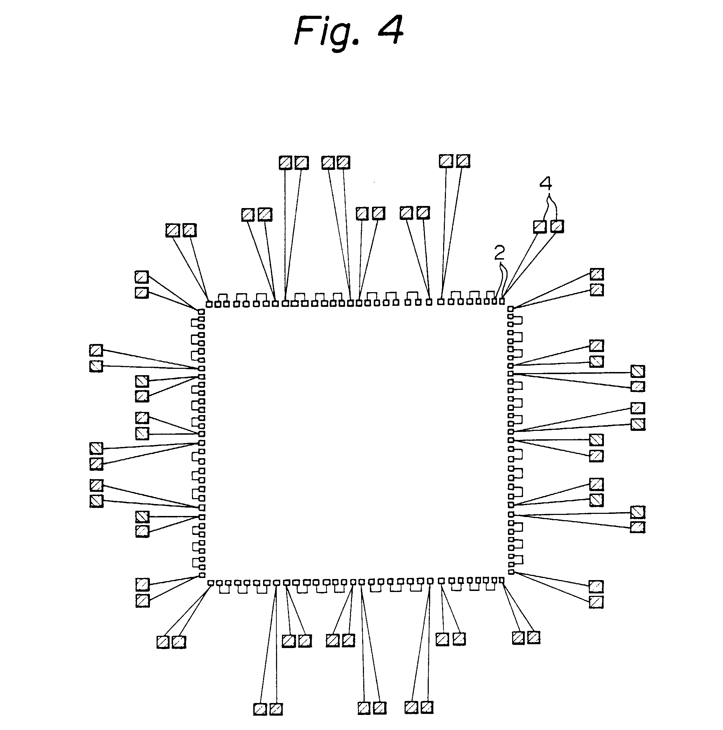

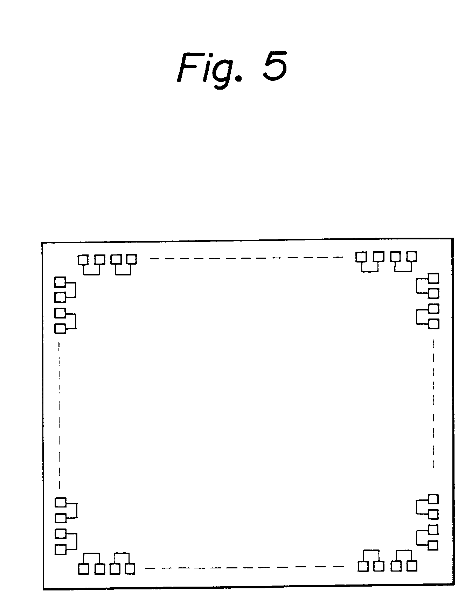

A 40 µm conductive adhesive agent prepared in (4) above was uniformly applied to a substrate (number of pads 128, interval between pads 100 µm, and size of pad 200 µm □) illustrated in Fig. 4. The substrate and a glass chip (128 pins) illustrated in Fig. 5 to which the substrate was tacked by bumping were subjected to thermocompression bonding at a temperature of 170°C for 30 sec and at 35 g/bump. In the diagram of Fig. 4, 2 represents an electrode and 4 represents an electrode to be used for such evaluations as a test for electrical continuity.

### (6) Test for electrical continuity and test for insulation

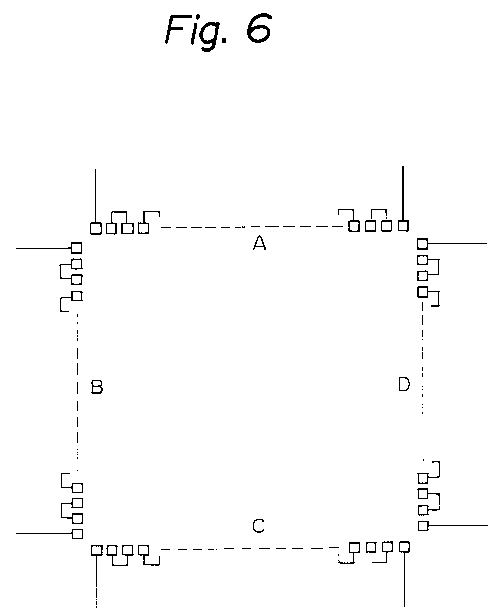

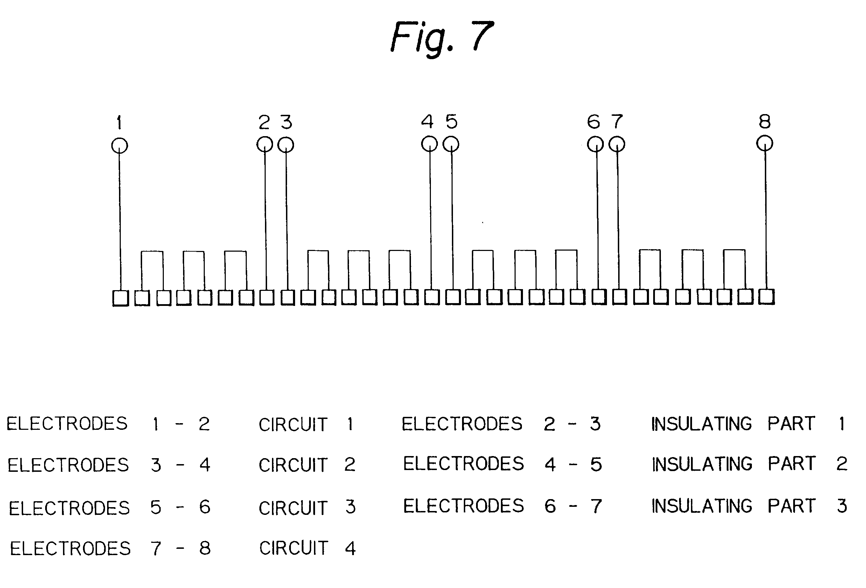

The product obtained by bonding in (5) above was tested for electrical continuity by the four-terminal method using the sites of measurement illustrated in Fig. 6 and Fig. 7 and was tested for insulation by using a high-resistance meter (insulation resistance meter).

Incidentally, the measurement of electrical continuity was made at circuit 1, circuit 2, circuit 3 and circuit 4 and that of insulation resistance at insulation part 1, insulation part 2, and insulation part 3 as illustrated in Fig. 7.

### (7) Observation of state of adhesion of chip to substrate

The product obtained by bonding in (5) above was sectioned and the cross section consequently exposed was visually examined to determine the state of adhesion of the filler to the chip and the substrate.

### Results

### Observation of cross section of microcapsule type conductive filler:

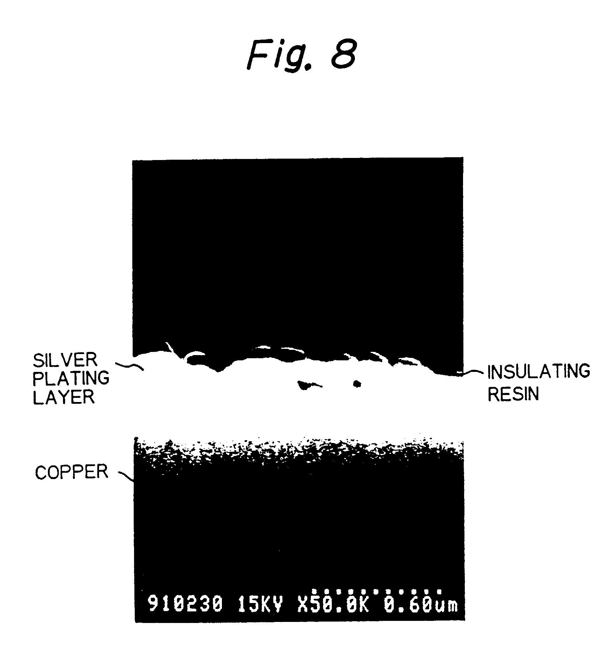

Fig. 8 is a photograph of a cross section of the microcapsule type conductive filler. It can be clearly seen from the photograph that an insulating polymer was present on the surface of a minute conductive particle, indicating that the particle was completely coated.

### Confirmation of insulation with microcapsule type conductive filler:

The two opposed glass substrates were found to be insulated from each other, indicating that the microcapsule type conductive filler served to effect insulation.

### Measurement of electrical continuity:

The results of the test for electrical continuity are shown in Table 1. All of the circuits used for the test invariably showed highly satisfactory results of electrical continuity not exceeding 1.5 Ω (not more than 0.2 Ω per joint).

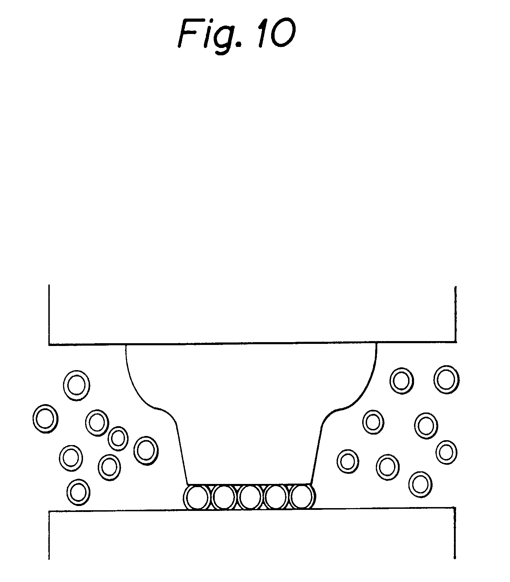

To be specific, the chip and the substrate were joined as illustrated in Fig. 10 and the electrical continuity resistance was not more than 0.2 Ω per joint and, in spite of the high filler content of 20% by volume, the adjacent patterns showed highly satisfactory insulation in the order of 1 x 10¹¹ Ω.

**Table 1**

| Electric continuity resistance | | | | |
|---|---|---|---|---|
| Side of measurement | Circuit 1 | Circuit 2 | Circuit 3 | Circuit 4 |
| A | 1.1034 | 1.1298 | 1.0865 | 1.2051 |
| B | 1.1298 | 1.2114 | 1.1695 | 1.1326 |
| C | 1.2365 | 1.1511 | 1.1233 | 1.1519 |
| D | 1.2562 | 1.1145 | 1.2314 | 1.1413 |
| In: Ω | | | | |

### Measurement of insulation resistance:

Table 2 shows the results of the test for insulation resistance. Even though the amount of filler incorporated was as large as 20% by volume (substantially equal to the amount of silver paste for a die bond), the adjacent patterns displayed highly satisfactory insulation of not less than 10¹¹ Ω.

**Table 2**

| Insulation resistance | | | |
|---|---|---|---|
| Side of measurement | Insulation 1 | Insulation 2 | Insulation 3 |
| A | 3.6 | 2.5 | 2.8 |
| B | 2.1 | 2.6 | 3.0 |
| C | 1.5 | 2.7 | 3.0 |
| D | 1.8 | 2.0 | 3.0 |
| In: 10¹¹ Ω | | | |

### Observation of state of union between chip and substrate (bump and pad)

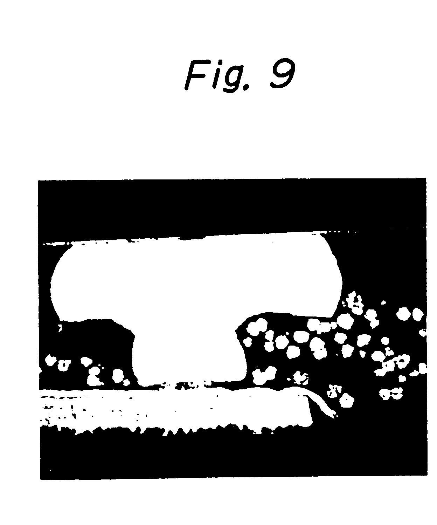

Fig. 9 is a photograph showing a cross section of the joint between the bump and the pad. It is clearly noted from this photograph that the microcapsule type conductive filler was amply present between the bump and the pad.

In an alternative procedure, silver powder was coated with cured BPA and TEPA according to the following method.

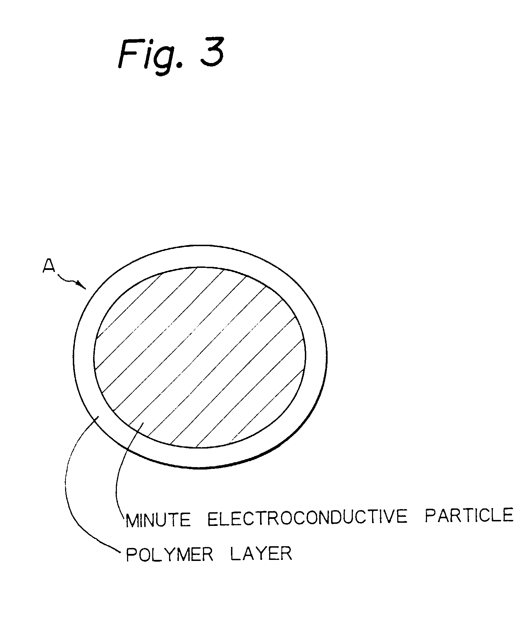

An aqueous phase was prepared by dissolving 25 g of polyvinyl alcohol, 2 g of an emulsifier, and 10 g of TEPA in 400 ml of water. An oil phase was prepared by dissolving 7 g of BPA in 15 ml of dichloroethane and adding to the resultant solution 15 g of silver powder treated with a titanate type coupling agent, as shown in the flow chart of Fig. 2. By exposing the oil phase to an ultrasonic wave for 20 minutes, the silver powder agglomerated therein was dispersed. Then, the aqueous phase was stirred with a homogenizer at a rate of 3,000 rpm and, at the same time, the oil phase was gradually added dropwise to the stirred aqueous phase to produce a suspension allowing the presence of the oil phase on the surface of the silver powder. This suspension was kept at 60°C and stirred with a three-one motor at a rate of 180 rpm for four hours. Thereafter, a microcapsule type conductive filler A having the surface of minute conductive particles (silver powder) coated with a polymer as illustrated in Fig. 3 was separated and dried at 60°C for 30 minutes, to provide an MC type conductive filler.

### Example 2

A microcapsule type conductive filler was produced by faithfully following the procedure of Example 1, except that minute Ag particles (average diameter 0.1 µm) were used as minute conductive particles. The filler was evaluated in the same manner as in Example 1.

### Results

### Observation of cross section of microcapsule type conductive filler:

Similar to the filler illustrated in Fig. 8, an insulating polymer was found to have uniformly coated the surface of agglomerated minute conductive particles.

### Confirmation of insulation with microcapsule type conductive filler:

The filler showed the same degree of insulation as found in Example 1.

### Measurement of electrical continuity resistance:

The electrical continuity resistance was substantially the same as in Example 1.

### Measurement of insulation resistance:

The insulation resistance was substantially the same as in Example 1.

### Observation of state of union between chip and substrate (bump and pad):

Similar to the product illustrated in Fig. 9, the microcapsule type conductive filler was amply present between the pad and the bump.

### Example 3

A microcapsule type conductive filler and adhesive agent were produced by faithfully following the procedure of Example 1, except that 10 g of bismaleimide (BMI) and 0.1 g of diazobicycloundecene were used in place of the monomer BPA. The resulting filler and adhesive agent were evaluated in the same manner as in Example 1.

### Results

### Observation of cross section of microcapsule type conductive filler:

Similar to the filler illustrated in Fig. 8, an insulating polymer was found to have coated minute conductive particles completely.

### Confirmation of insulation with microcapsule type conductive filler:

The filler showed the same degree of insulation as in Example 1.

### Measurement of electrical continuity resistance:

The filler showed the same degree of electrical continuity resistance as in Example 1.

### Measurement of insulation resistance:

The filler showed the same degree of insulation resistance as in Example 1.

### Observation of state of union between chip and substrate (bump and pad):

The state of union was the same as that found in Example 1.

### Comparative Example 1

A microcapsule type conductive filler was produced by the coating method described below and using the following materials.

Minute conductive particles: 30 g of minute Ag/Cu particles (same as those of Example 1)

Polymer: PMMA (average particle diameter 0.15 µm) (m.p. 135°C)

A microcapsule type conductive filler coated with PMMA was produced by dissolving 5 g of PMMA in 100 ml of xylene, spraying the resultant solution onto the minute conductive particles, and drying the particles to expel the xylene.

The following evaluations were carried out in the same way and under the same conditions as Example 1.

### Results

### Observation of cross section of microcapsule type conductive filler:

Similar to the minute conductive particles of Example 1 illustrated in Fig. 8, the filler particles were found to be completely coated with PMMA.

### Confirmation of insulation with microcapsule type conductive filler:

Similar to the filler of Example 1, the microcapsule type conductive filler retained insulation.

### Measurement of electrical continuity resistance:

All the circuits, similar to those of Example 1, showed highly satisfactory electric continuity resistance of not more than 1.5 Ω.

### Measurement of insulation resistance:

Table 3 shows the results of the measurement. Of the total of 12 insulation parts, two insulation parts showed electrical continuity, probably because the bonding was made at a temperature of 200°C and the PMMA was consequently decomposed or fused to establish contact between the minute conductive particles.

**Table 3**

| Insulation resistance | | | |
|---|---|---|---|
| Side of measurement | Insulation 1 | Insulation 2 | Insulation 3 |
| A | 1.5 | 2.5 × 10¹¹ | 510 |
| B | 2.1 × 10¹¹ | 8 | 150 |
| C | 20 | 2.7 × 10¹¹ | 26 |
| D | 35 | 10 | 3.0 × 10¹¹ |
| In: Ω | | | |

### State of union between bump and pad:

Similar to the results in Example 1, the microcapsule type conductive filler was amply present between the bump and the pad.

### Comparative Example 2

A microcapsule type conductive filler was produced by faithfully following the procedure of Example, except that Cu particles of 60 µm diameter were used as minute conductive particles.

The produced microcapsule type conductive filler was evaluated in the same manner and under the same conditions as described in Example 1.

The produced filler having the surface thereof completely coated with a polymer showed insulation. The electrical continuity resistance and the state of union between the bump and the pad were equal to those obtained in Example 1. No insulation was retained between the adjacent pads.

### Comparative Example 3

A microcapsule type conductive filler produced by following the procedure of Example 1 was mixed with an epoxy type adhesive agent having a viscosity of 210,000 cps.

The filler could not be dispersed in the adhesive agent because the viscosity of the adhesive agent was unduly high.

### Example 4

In this Example, two kinds of monomers were used, one in the oil phase and one in the aqueous phase, which produce a thermosetting resin.

A microcapsule type conductive filler and a microcapsule type conductive adhesive agent were produced by faithfully following the procedure of Example 1, except that the oil phase was obtained by dispersing 7 g of conductive particles treated with a coupling agent in 10 g of BPA in dichloroethane instead of ethyl acetate solvent.

The resulting filler and adhesive agent were evaluated in the same manner as in Example 1.

In all the items of evaluation, the results were equal to those obtained in Example 1.

### Example 5

A microcapsule type conductive filler and a microcapsule type conductive adhesive agent were produced by following the procedure of Example 1, except that the aqueous phase was prepared by dissolving 12 g of polyvinyl alcohol and 1.5 g of an emulsifier in 200 ml of water, and a solution of 10 g of divinyl benzene and 0.1 g of benzoyl peroxide in 15 ml of ethyl acetate was used as an oil phase.

In all the items of evaluation, the results were almost the same as those obtained in Example 1.

### Example 6

A microcapsule type conductive filler and a microcapsule type conductive adhesive agent were produced by following the procedure of Example 1, except that the aqueous phase was prepared by dissolving 12 g of polyvinyl alcohol and 1.5 g of an emulsifier in 200 ml of water and an oil phase was prepared with 15 ml of ethyl acetate and 5 g of imidazole. They were evaluated in the same manner as in Example 1.

In all the items of evaluation, the results were nearly the same as those obtained in Example 1.

### Example 7

An MC filler and an MC conductive adhesive agent were produced by faithfully following the procedure of Example 6, except that the use of ethyl acetate was omitted. They were evaluated in the same manner as in Example 6.

In all the items of evaluation, the results were nearly the same as those obtained in Example 1.

### Example 8

A microcapsule type conductive filler and a microcapsule type conductive adhesive agent were produced by following the procedure of Example 2, except that the aqueous phase was prepared by dissolving 12 g of polyvinyl alcohol and an emulsifier in 200 ml of water. The oil phase was prepared by dispersing in 10 g of divinyl benzene, 0.1 g of benzoyl peroxide and 7 g of minute conductive particles treated with a coupling agent in accordance with the flow sheet illustrated in Fig. 2 without using ethyl acetate (solvent). They were evaluated in the same manner as in Example 2.

In all the items of evaluation, the results were nearly the same as those obtained in Example 1.

### Example 9

A blend of a thermoplastic resin and a thermosetting resin and a solvent were used. The monomer was used in the oil phase.

A microcapsule type conductive filler and a microcapsule type conductive adhesive agent were produced by following the procedure of Example 1, except that 5 g of methyl methacrylate, 5 g of bismaleimide, and 0.1 g of azoisobutyronitrile were used as monomers in place of BPA and TEPA. They were evaluated in the same manner as in Example 1.

In all the items of evaluation, the results were nearly the same as those obtained in Example 1.

### Example 10

A blend of a thermoplastic resin and a thermosetting resin and a solvent were used. The monomer was used in the oil phase and the aqueous phase.

A microcapsule type conductive filler and a microcapsule type conductive adhesive agent were produced by following the procedure of Example 1, except that the aqueous solution was prepared by dissolving 12 g of polyvinyl alcohol, 1.5 g of an emulsifier, and 15 g of hexamethylene diamine in 200 ml of water, and a solution of 7 g of adipic acid and 7 g of BPA in 15 ml of ethyl acetate was used as the oil phase. They were evaluated in the same manner as in Example 1.

In all the items of evaluation, the results were nearly the same as those obtained in Example 1.

### Example 11

A blend of monomers was used in the oil phase and no solvent was used in the oil phase.

An MC filler and an MC type conductive adhesive agent were produced by following the procedure of Example 10, except that ethyl acetate was omitted from the oil phase. They were evaluated in the same manner as Example 10.

In all the items of evaluation, the results were nearly the same as those obtained in Example 1.

### Example 12

A blend of monomers was used in the oil phase (adipic acid and BPA) and the aqueous phase (hexamethylene diamine) and no solvent was used in the oil phase.

An MC type filler and an MC type conductive adhesive agent were produced by following the procedure of Example 11. They were evaluated in the same manner as in Example 11.

In all the items of evaluation, the results were nearly the same as those obtained in Example 1.

### Example 13

An MC type filler produced by the procedure of Example 1 was tested for the following items.

### (1) Effect of sp (solubility parameter) value of coupling agent on production of MC type filler

Table 4 shows the results of the test performed on MC fillers prepared using coupling agents of different sp values with respect to electrical continuity.

**Table 4**

| Results of test of MC type filler for insulation | |
|---|---|
| Difference of sp values of coupling agent and monomer | Results of test for insulation |
| 0 | Insulation |
| 5 | Insulation |
| 10 | Insulation |
| 11 | Electric continuity |

The results indicate that the difference between the sp value of the monomer (epoxy resin) and the sp value of the coupling agent must be within 10 (cal/cm³)^{½}. A possible reason for this is that, outside this limit, the monomer molecules and the coupling agent molecules intertwine with difficulty and the monomer is not retained on the surface of the minute conductive particles. Incidentally, the sp value of the epoxy resin is 10.9 (cal/cm³)^{½}.

### (2) Effect of viscosity of aqueous phase on stability of suspension

Table 5 shows the results of the test performed to investigate the effect of the viscosity of the aqueous phase on the stability of the suspension.

**Table 5**

| Relation between viscosity of aqueous phase and suspension | | | | | | |
|---|---|---|---|---|---|---|
| Viscosity of aqueous phase (cps) | 10 | 20 | 100 | 1000 | 10000 | 11,000 |
| Stability of suspension | Sedimentation of minute conductive particles observed | Stable | Stable | Stable | Stable | Suspension not producible and separation of MC filler after reaction not effectible |

The results indicate that the viscosity of the aqueous solution should be in the range of 20 to 10,000 cps. to investigate the effect of the stirring speed on the stability of the suspension.

**Table 6**

| Relation of speed of stirring and stability of suspension | | | | |
|---|---|---|---|---|
| Speed of stirring | 30 | 50 | 250 | 300 |
| Stability of suspension | Sedimentation of minute conductive particles observed | Stable | Stable | Adhesion of minute conductive particles to beaker wall observed |

The results indicate that the stirring must be carried out at a rate in a range of 50 to 250 rpm.

### (4) Relationship between particle diameter and insulation resistance of minute conductive particles

Table 7 shows the results of the test performed to investigate the insulation of minute conductive particles of diameters 10, 30, 50, and 70 µm.

**Table 7**

| Relation between particle diameter and insulating property of coated minute conductive particles | |
|---|---|
| Particle diameter (µm) of minute conductive particles | Results of test for insulation |
| 10 | Insulation |
| 30 | Insulation |
| 50 | Insulation |
| 70 | Electric continuity |

The results indicate that the minute conductive particles to be used should have a diameter of not more than 50 µm.

### (5) Relationship between shape and electric continuity resistance of minute conductive particles.

Table 8 shows the results of the test performed to investigate the effect on electrical continuity of minute conductive particles having different shapes; spheres, pseudospheres, and fish scales.

**Table 8**

| Relation between shape and conductivity of minute conductive particles | |
|---|---|
| Shape of minute conductive particles | Conductivity (Number of defective portions/number of sites of measurement) |
| Spheres | 0/100 |
| Pseudospheres | 0/100 |
| Fish scales | 23/100 |

In the case of a filler using minute particles of the shape of fish scales and the surface completely coated with a polymer, the insulation was satisfactory, and the adjacent pads were insulated from each other. Absolutely no electrical continuity was established. Although the filler was present between the bump and the pad, it failed to serve as a medium for union thereof. The results indicate that the minute conductive particles should be in the shape of either spheres or pseudospheres.

### (6) Relationship between thickness and electric continuity resistance of an insulating resin layer

Table 9 shows the results of the test performed to investigate the effect on electrical continuity of MC type conductive fillers with insulating resin layers different thicknesses.

**Table 9**

| Relation between thickness and conductivity of insulating resin | |
|---|---|
| Thickness (µm) of insulating resin | Resistance per site of measurement (Ω) |
| 0.1 | 0.1 |
| 2.0 | 0.4 |
| 3.0 | 0.5 |
| 4.0 | 1.5 |

It is noted from Table 9 that the resistance to electrical continuity was high and points of poor electrical continuity were detected when the thickness of the insulating resin layer (coating layer) was 4.0 µm. The results indicate that the thickness of the insulating resin layer is desired to be not more than 3 µm.

### (7) Content of MC type filler

Table 10 shows the relationship between the MC type filler and the state of curing of the adhesive agent.

**Table 10**

| Content of MC type conductive filler and state of adhesive agent | | | | | | | |
|---|---|---|---|---|---|---|---|
| Content (%) | 1 | 10 | 30 | 50 | 55 | 65 | 70 |
| State of curing | Good | Good | Good | Good | Good | Poor adhesion | Poor adhesion |

Poor adhesion: Complete wetting of filler with adhesive agent not obtained because of excess amount of filler.

The results indicate that the content of the MC type conductive filler must not be more than 60% by volume.

## Claims

1. A process for the production of a microcapsule (MC) type conductive filler, characterised by:
(a) treating minute conductive particles with a coupling agent;
(b) preparing an oil phase by adding said minute conductive particles to a solvent having dissolved therein a reactive substance A having a solubility parameter which is within ±10 (cal/cm³)^{½} (1 cal = 4.186J) of the solubility parameter of said coupling agent, so that said minute conductive particles have said reactive substance A directly on the surface thereof;
(c) dispersing said oil phase in water to form a suspension of said oil phase in water, said water including a reactive substance B capable of reacting with the reactive substance A and a viscosity enhancer such that the viscosity thereof is in the range of from 20 to 10,000 cps; and
(d) stirring said suspension at a rate in the range of from 50 to 250 rpm, and applying heat or adding a catalyst to the suspension to cause said reactive substances A and B to react on the surface of said minute conductive particles and thereby form a coating of a thermosetting, thermoplastic or combined thermosetting/thermoplastic insulating resin on the surface of said minute conductive particles, depending on the nature of the reactive substances A and B.

2. A method as claimed in claim 1, wherein said one of reactive substance A and said reactive substance B is such that a thermosetting coating of epoxy resin, in particular an epoxy/amine type curing substance or a bismaleimide/amine type curing substance, is formed on the minute conductive particles.

3. A process for the production of a microcapsule (MC) type conductive filler, characterised by:
(a) treating minute conductive particles with a coupling agent;
(b) preparing an oil phase by adding said minute conductive particles to a solvent having dissolved therein a reactive substance A having a solubility parameter which is within ±10 (cal/cm³)^{½} (1 cal = 4.186J) of the solubility parameter of said coupling agent, so that said minute conductive particles have said reactive substance A directly on the surface thereof;
(c) dispersing said oil phase in water to form a suspension of said oil phase in water, said water including a viscosity enhancer such that the viscosity thereof is in the range of from 20 to 10,000 cps; and
(d) stirring said suspension at a rate in the range of from 50 to 250 rpm, and applying heat or adding a catalyst to the suspension to cause said reactive substance A to react on the surface of said minute conductive particles and thereby form a coating of a thermosetting or thermoplastic insulating resin on the surface of said minute conductive particles, depending on the nature of the reactive substance A.

4. A process as claimed in claim 3, wherein said reactive substance A is a divinyl benzene monomer or an acryl monomer.

5. A method as claimed in claim 1, 2, 3 or 4, wherein said minute conductive particles are of Ag or of Cu having an Ag coating.

6. A method as claimed in any preceding claim, wherein said minute conductive particles are spherical or pseudospherical.

7. A method as claimed in claim 6, wherein said minute conductive particles have a diameter of not more than 50 µm.

8. An MC type conductive filler produced by the method of any preceding claim, said coating having a thickness of not more than 3 µm.

9. An MC type conductive adhesive agent having dispersed in an adhesive agent an MC type conductive filler as claimed in claim 8.

10. An MC type conductive adhesive agent as claimed in claim 9, wherein said adhesive agent is an epoxy type one-component adhesive agent.

11. An MC type conductive adhesive agent as claimed in claim 9 or claim 10, wherein said MC type conductive adhesive agent has a viscosity of not more than 150,000 cps.

12. An MC type conductive adhesive agent as claimed in claim 9, 10 or 11, said MC type conductive filler is not more than 60% by volume of said MC type conductive adhesive agent.

## Patentansprüche

1. Verfahren zur Herstellung eines leitfähigen Füllstoffs vom Mikrokapsel (MC)-Typ, gekennzeichnet durch:
(a) Behandeln winziger leitfähiger Teilchen mit einem Kopplungsmittel;
(b) Erzeugen einer Ölphase durch den Zusatz der winzigen leitfähigen Teilchen zu einem Lösungsmittel, das darin gelöst eine reaktive Substanz A mit einem Löslichkeitsparameter aufweist, der innerhalb von ± 10 (cal/cm³)^{½} (1 cal = 4,186 J) des Löslichkeitsparameters des Kopplungsmittels liegt, so daß die winzigen leitfähigen Teilchen die reaktive Substanz A direkt auf der Oberfläche davon aufweisen;
(c) Dispergieren der Ölphase in Wasser, um eine Suspension der Ölphase in Wasser zu bilden, wobei das Wasser eine reaktive Substanz B, die mit der reaktiven Substanz A reagieren kann, und einen Viskositätsverstärker enthält, so daß die Viskosität davon im Bereich von 20 bis 10 000 cps liegt; und
(d) Rühren der Suspension bei einer Rate im Bereich von 50 bis 250 UpM, und Zuführen von Wärme oder Zusetzen eines Katalysators zur Suspension, um zu bewirken, daß die reaktiven Substanzen A und B an der Oberfläche der winzigen leitfähigen Teilchen reagieren, und dadurch eine Beschichtung aus einem thermohärtenden, thermoplastischen oder kombinierten thermohärtenden/thermoplastischen Isolierharz an der Oberfläche der winzigen leitfähigen Teilchen in Abhängigkeit von der Beschaffenheit der reaktiven Substanzen A und B bilden.

2. Verfahren nach Anspruch 1, bei welchem die eine der reaktiven Substanz A und der reaktiven Substanz B derart ist, daß eine thermohärtende Beschichtung aus Epoxyharz, insbesondere eine Aushärtungssubstanz vom Epoxy/Amin-Typ oder eine Aushärtungssubstanz vom Bismaleimid/Amin-Typ, auf den winzigen leitfähig Teilchen gebildet wird.

3. Verfahren zur Herstellung eines leitfähigen Füllstoffs vom Mikrokapsel (MC)-Typ, gekennzeichnet durch:
(a) Behandeln winziger leitfähiger Teilchen mit einem Kopplungsmittel;
(b) Erzeugen einer Ölphase durch den Zusatz der winzigen leitfähigen Teilchen zu einem Lösungsmittel, das darin gelöst eine reaktive Substanz A mit einem Löslichkeitsparameter aufweist, der innerhalb von ± 10 (cal/cm³)^{½} (1 cal = 4,186 J) des Löslichkeitsparameters des Kopplungsmittels liegt, so daß die winzigen leitfähigen Teilchen die reaktive Substanz A direkt auf der Oberfläche davon aufweisen;
(c) Dispergieren der Ölphase in Wasser, um eine Suspension der Ölphase in Wasser zu bilden, wobei das Wasser einen Viskositätsverstärker enthält, so daß die Viskosität davon im Bereich von 20 bis 10 000 cps liegt; und
(d) Rühren der Suspension bei einer Rate im Bereich von 50 bis 250 UpM, und Zuführen von Wärme oder Zusetzen eines Katalysators zur Suspension, um zu bewirken, daß die reaktive Substanz A an der Oberfläche der winzigen leitfähigen Teilchen reagiert, und dadurch eine Beschichtung aus einem thermohärtenden oder thermoplastischen Isolierharz an der Oberfläche der winzigen leitfähigen Teilchen in Abhängigkeit von der Beschaffenheit der reaktiven Substanz A bildet.

4. Verfahren nach Anspruch 3, bei welchem die reaktive Substanz A ein Divinylbenzol-Monomer oder ein Acryl-Monomer ist.

5. Verfahren nach Anspruch 1, 2, 3 oder 4, bei welchem die winzigen leitfähigen Teilchen aus Ag oder aus Cu mit einer Ag-Beschichtung bestehen.

6. Verfahren nach einem der vorhergehenden Ansprüche, bei welchem die winzigen leitfähigen Teilchen sphärisch oder pseudosphärisch sind.

7. Verfahren nach Anspruch 6, bei welchem die winzigen leitfähigen Teilchen einen Durchmesser von nicht mehr als 50 µm aufweisen.

8. Leitfähiger Füllstoff vom MC-Typ, welcher durch das Verfahren nach einem der vorhergehenden Ansprüche hergestellt wird, wobei die Beschichtung eine Dicke von nicht mehr als 3 µm hat.

9. Leitfähiges Haftmittel vom MC-Typ, welches in einem Haftmittel dispergiert einen leitfähigen Füllstoff vom MC-Typ nach Anspruch 8 aufweist.

10. Leitfähiges Haftmittel vom MC-Typ nach Anspruch 9, wobei das Haftmittel ein Einkomponenten-Haftmittel vom Epoxy-Typ ist.

11. Leitfähiges Haftmittel vom MC-Typ nach Anspruch 9 oder Anspruch 10, wobei das leitfähige Haftmittel vom MC-Typ eine Viskosität von nicht mehr als 150 000 cps aufweist.

12. Leitfähiges Haftmittel vom MC-Typ nach Anspruch 9, 10 oder 11, wobei der leitfähige Füllstoff vom MC-Typ nicht mehr als 60 Vol.% des leitfähigen Haftmittels vom MC-Typ ausmacht.

## Revendications

1. Procédé de production d'une charge conductrice de type MC, caractérisé par :
(a) le traitement de minuscules particules conductrices par un agent d'accrochage,
(b) la préparation d'une phase huileuse par addition des minuscules particules conductrices à un solvant dans lequel est dissoute une substance réactive A ayant un paramètre de solubilité qui ne diffère pas de plus de ±10 (cal/cm³)^{1/2} (1 cal = 4,186 J) du paramètre de solubilité de l'agent d'accrochage, si bien que les minuscules particules conductrices ont la substance réactive A directement à leur surface,
(c) la dispersion de la phase huileuse dans de l'eau pour la formation d'une suspension de la phase huileuse dans l'eau, l'eau contenant une substance réactive B qui peut réagir avec la substance réactive A et un agent d'accroissement de viscosité tel que sa viscosité est comprise entre 20 et 10 000 cP, et
(d) l'agitation de la suspension à une vitesse comprise entre 50 et 250 tr/min, et l'application de chaleur ou l'addition d'un catalyseur à la suspension de manière que les substances réactives A et B réagissent à la surface des minuscules particules conductrices et forment ainsi un revêtement d'une résine isolante thermodurcissable, thermoplastique ou combinée thermodurcissable-thermoplastique à la surface des minuscules particules conductrices, suivant la nature des substances réactives A et B.

2. Procédé selon la revendication 1, dans lequel l'une des substances réactives A et B est telle qu'un revêtement thermodurcissable d'une résine époxyde, en particulier d'une substance polymérisant de type époxyde-amide ou de type bismaléimide-amide, est formé sur les minuscules particules conductrices.

3. Procédé de production d'une charge conductrice du type à microcapsules (MC), caractérisé par :
(a) le traitement de minuscules particules conductrices par un agent d'accrochage,
(b) la préparation d'une phase huileuse par addition des minuscules particules conductrices à un solvant dans lequel est dissoute une substance réactive A ayant un paramètre de solubilité qui ne diffère pas de plus de ±10 (cal/cm³)^{1/2} (1 cal = 4,186 J) du paramètre de solubilité de l'agent d'accrochage, si bien que les minuscules particules conductrices ont la substance réactive A directement à leur surface,
(c) la dispersion de la phase huileuse dans l'eau pour la formation d'une suspension de la phase huileuse dans l'eau, l'eau contenant un agent d'accroissement de viscosité tel que sa viscosité est comprise entre 20 et 10 000 cP, et
(d) l'agitation de la suspension à une vitesse comprise entre 50 et 250 tr/min, et l'application de chaleur ou l'addition d'un catalyseur à la suspension afin que la substance réactive A réagisse à la surface des minuscules particules conductrices et forme ainsi un revêtement d'une résine isolante thermodurcissable ou thermoplastique à la surface des minuscules particules conductrices, suivant la nature de la substance réactive A.

4. Procédé selon la revendication 3, dans lequel la substance réactive A est un monomère de divinylbenzène ou un monomère acrylique.

5. Procédé selon la revendication 1, 2, 3 ou 4, dans lequel les minuscules particules conductrices sont formées de Ag ou Cu ayant un revêtement de Ag.

6. Procédé selon l'une quelconque des revendications précédentes, dans lequel les minuscules particules conductrices sont sphériques ou pseudosphériques.

7. Procédé selon la revendication 6, dans lequel les minuscules particules conductrices ont un diamètre ne dépassant pas 50 µm.

8. Charge conductrice de type MC produite par le procédé selon l'une quelconque des revendications précédentes, le revêtement ayant une épaisseur qui ne dépasse pas 3 µm.

9. Agent adhésif conducteur de type MC dans lequel une charge conductrice de type MC selon la revendication 8 est dispersée dans un agent adhésif.

10. Agent adhésif conducteur de type MC selon la revendication 9, dans lequel l'agent adhésif est un agent adhésif à un composant de type époxyde.

11. Agent adhésif conducteur de type MC selon la revendication 9 ou 10, dans lequel l'agent adhésif conducteur de type MC a une viscosité qui ne dépasse pas 150 000 cP.

12. Agent adhésif conducteur de type MC selon la revendication 9, 10 ou 11, dans lequel la charge conductrice de type MC ne dépasse pas 60 % en volume de l'agent adhésif conducteur de type MC.
